# EUROPÄISCHE PATENTSCHRIFT

(11) **EP 0 688 069 B1**
(45) Veröffentlichungstag und Bekanntmachung des Hinweises auf die Patenterteilung: **19.03.1997**
(21) Anmeldenummer: 95109020.8
(22) Anmeldetag: 12.06.1995
(51) Int. Cl.: H01S 3/085, H01S 3/103, H01S 3/025

(54) **Interferometrischer Halbleiterlaser mit Verlustarmer Lichtauskopplung und Anordnung mit einem solchen Laser**
Interferometric semiconductor laser with low loss outcoupler and assembly comprising such a laser
Laser à semi-conducteur interférométrique avec découplage à perte faible et assemblage comprenant ce laser

(30) Priorität: 17.06.1994 DE 4421043
(43) Veröffentlichungstag der Anmeldung: 20.12.1995
(73) Patentinhaber: Alcatel SEL Aktiengesellschaft, D-70435 Stuttgart (DE); ALCATEL N.V., NL-2288 BH Rijswijk (NL)
(72) Erfinder: Dütting, Kaspar, D-70182 Stuttgart (DE); Wünstel, Klaus, Dr., D-71701 Schwieberdingen (DE)
(74) Vertreter: Pechhold, Eberhard, Dipl.-Phys.

(56) Entgegenhaltungen:
- EP-A- 0 418 705
- APPLIED PHYSICS LETTERS, Bd. 52, Nr. 10, 7.März 1988 NEW YORK US, Seiten 767-769, J. SALZMAN ET AL 'Cross-coupled cavity semiconductor laser'
- PATENT ABSTRACTS OF JAPAN, Bd. 010, Nr. 133(E-404), 17. Mai 1986;& JP-A-60263488
- IEEE JOURNAL OF QUANTUM ELECTRONICS, Bd. 29, Nr. 6, 1.Juni 1993 Seiten 1835-1843, XP 000397621 SCHILLING M ET AL '6 THZ RANGE TUNABLE 2.5 GB/S FREQUENCY CONVERSION BY A MULTIQUANTUM WELL Y LASER'

## Beschreibung

Die Erfindung betrifft einen interferometrischen Halbleiterlaser gemäß dem Oberbegriff des Patentanspruchs 1 und Anordnungen mit einem solchen Laser.

Interferometrische Laser zeichnen sich dadurch aus, daß sie in einem großen Wellenlängenbereich Licht emittieren können. In geeigneter Ausführung und elektrischer Beschaltung sind sie über einen Wellenlängenbereich von über 50 nm hinweg elektrisch durchstimmbar und eignen sich somit hervorragend für viele Aufgaben in der optischen Nachrichtenübertragungstechnik. In einem Aufsatz von M. Schilling et al in JEEE Journal of Quantum Electronics, Vol. 26, No. 6, June 1993, wird ausführlich über einen asymmetrischen Y-Laser berichtet.

Interferometrische Laser haben mindestens 3 Spiegel oder Reflexionsstellen oder -bereiche. Diese sind für die interne Filterfunktion des jeweiligen Lasers notwendig. Sowohl eine diskrete, als auch eine monolithische Ankopplung eines Wellenleiters an einem der Spiegel erfordert einen Übergang Halbleiter / Luft / Halbleiter, der mit großen Einkoppelverlusten behaftet ist. Wird bei der monolithischen Integration an einem der 3 Spiegel der Übergang effizienter gestaltet, z.B. durch einen Gitter-Reflexions-Bereich in einem durchgehenden oder stoßgekoppelten Wellenleiter, so wird die Filterfunktion des interferometrischen Lasers beeinflußt und sein ursprünglich weiter Durchstimmbereich eingeschränkt.

Der Erfindung liegt deshalb die Aufgabe zugrunde, einen interferometrischen Laser zu schaffen, bei dem es möglich ist, höhere optische Leistung auszukoppeln, ohne die Filterfunktion und damit die Wellenlängenstabilität zu beeinflussen oder den Durchstimmbereich wesentlich einzuschränken.

Diese Aufgabe wird durch die im Patentanspruch 1 angegebenen Merkmale gelöst.

Der interferometrische Laser nach der Erfindung besitzt zusätzlich mindestens ein vom Koppelsegment abzweigendes, weitgehend reflexionsfrei abgeschlossenes Lichtauskoppelsegment. Damit wird ein Verlustausgang geschaffen, über den dem Laser hohe optische Leistung entnommen werden kann, ohne dessen Filtereigenschaften zu verändern. Dies ermöglicht eine Kopplung des Lasers mit anderen optoelektronischen Bauelementen auch ohne Zwischenschaltung eines optischen Verstärkers, durch Verwendung passiver Wellenleiter. Dazuhin können verlustbehaftete optische Übergänge wie Stoß-Kopplungen oder Kopplungen über Glasfaserstrecken, wie sie in hybrid aufgebauten optoelektronischen Schaltungen erforderlich sind, jetzt in vielen Fällen durch monolithische Integration des interferometrischen Lasers mit den nachfolgenden Bauelementen vermieden werden. Als besonders vorteilhaft hat sich ein gemäß der Erfindung ausgebildeter Y-Laser gemäß Patentanspruch 2 erwiesen.

Eine weitere Aufgabe im Zusammenhang mit der Schaffung des im Patentanspruch 1 wiedergegebenen interferometrischen Lasers besteht darin, optoelektronische Anordnungen anzugeben, in denen der interferometrische Laser nach der Erfindung vorteilhaft eingesetzt werden kann.

Derartige Anordnungen sind in den Patentansprüchen 3 bis 10 beschrieben.

In derartigen Anordnungen, besonders dann, wenn diese wie in Anspruch 4, monolithisch integriert aufgebaut werden, läßt sich das nachgeschaltete optoelektronische Bauelement auf einfache Weise mit ausreichender optischer Leistung einer einstellbaren Wellenlänge versorgen.

Mit einer gemäß Anspruch 5 ausgebildeten derartigen Anordnung läßt sich die ausgekoppelte, hohe optische Leistung nahezu verlustfrei vom Laser zu dem nachfolgenden optischen Bauelement übertragen.

Die Ansprüche 7 bis 10 geben Anordnungen an, in denen bestimmte optoelektronische Bauelemente mit dem erfindungsgemäßen Laser optisch gekoppelt sind und dadurch besondere Vorteile erlangen.

Letzteres gilt insbesondere für in den Anordnungen nach Anspruch 9 und Anspruch 10 vorgesehene Wellenlängenkonverter. Derartige Wellenlängenkonverter bestehen aus einem oder mehreren optischen Halbleiterverstärkern (SOAs) und sind z.B. in einem Aufsatz einer Autorengruppe der Techn. Universität Lyngby, Dänemark und des Forschungszentrums der Alcatel Alsthom in Marcoussis, Frankreich, beschrieben, der auf der ECOC'93 (19th European Conference on Optical Communication, 12-16 Sept. 1993, Montreux) öffentlich vorgetragen wurde und auch als Konferenzpapier (Proceedings, Vol. 1, Seiten 60 bis 67) vorliegt.

Da die Übertragungsgeschwindigkeit solcher zur optischen Nachrichtenübertragung verwendeter Wellenlängenkonverter durch die Änderungszeit kleinster Brechungsindexvariationen begrenzt ist, sind sie extrem schnell und können einen Laser übertreffen, dessen Übertragungsgeschwindigkeit durch seine Resonanzfrequenz begrenzt ist.

Anordnungen, in denen z.B. ein durchstimmbarer Y-Laser mit Lichtauskoppelsegment in einen nachgeschalteten derartigen Wellenlängenkonverter ausreichend hohe optische Leistung einspeist, sind deshalb hervorragend zur Verteilung von Information auf eine Vielzahl von Wellenlängenkanälen geeignet.

Es können jedoch auch andere optoelektronische Bauelemente, z.B. gemäß den Ansprüchen 7 und 8, optische Raumschalter und optische Speicher vorteilhaft mit einem interferometrischen Laser nach der Erfindung gekoppelt werden.

Anhand von 3 Figuren sollen nachfolgend Ausführungsbeispiele des interferometrischen Halbleiterlaser nach der Erfindung und diesen Laser enthaltender optoelektronischer Anordnungen ausführlich beschrieben werden.
- Fig. 1: zeigt Y-Laser mit je einem Lichtauskoppelsegment,
- Fig. 2 und Fig. 3: zeigen monolithisch integrierte optoelektronische Anordnungen mit je einem Y-Laser und einem Wellenlängenkonverter.

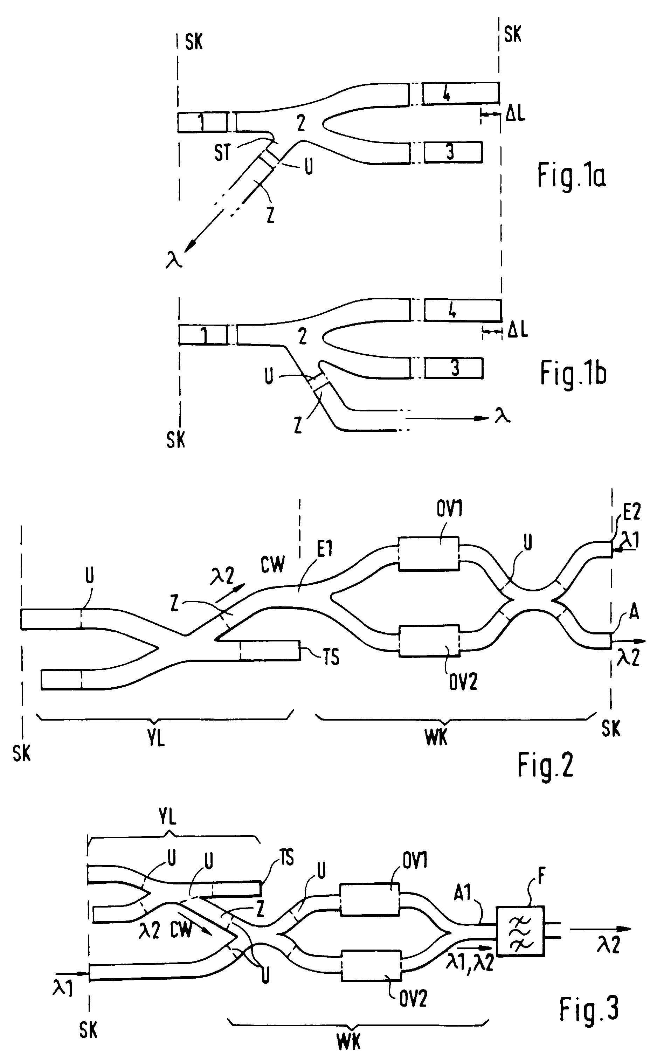

In Fig. 1 a) und b) sind interferometrische Laser nach der Erfindung wiedergegeben. In diesem Falle sind dies sogenannte Y-Laser, wie sie aus dem eingangs zitierten Aufsatz von M. Schilling bekannt sind, die mit einem Lichtauskoppelsegment Z versehen wurden. Das Lichtauskoppelsegment beginnt an einem Koppelsegment 2 des Y-Lasers, das die anderen Segmente, das Wurzelsegment 1 und die Armsegmente 3 und 4 miteinander verbindet, und endet reflexionsfrei am Übergang zu einem - in Fig. 1 nicht dargestellten - nachgeschalteten optischen Bauelement, welches Licht aus dem Y-Laser zugeführt bekommt.

An die Stelle des Y-Lasers kann auch ein anderer interferometrischer Laser, z.B. ein kreuzförmiger Laser treten. Die Anzahl der Lasersegmente - hier die Mindestzahl 4 - kann auch höher sein. Auch weitere, zusätzliche Lichtauskoppelsegmente können vorgesehen und unabhängig voneinander zur Lichtauskopplung benutzt werden. Die Armsegmente 3, 4 des Y-Lasers, die hier unterschiedlich lang ausgebildet sind, um für das Auftreten des Mach-Zehnder Effektes erforderliche unterschiedliche Resonanzfrequenzen in den in die beiden Arme hineinreichenden Lichtwegen zu erzeugen, können auch gleichlang sein. Die erforderliche Unsymmetrie kann dann durch unterschiedliche Stromflüsse durch die Armsegmente hergestellt werden.

Form und Größe des Lichtauskoppelsegmentes Z sind dabei, wie bei den anderen Segmenten des Y-Lasers auch, durch die verlustärmste Wellenführung und Strahlteilung einer oder mehrerer Moden bestimmt. Die Länge der Metallelektrode spielt eine untergeordnete Rolle und kann entsprechend den anderen Segmentelektroden dimensioniert werden.

Eine elektrische Unterbrechung U zwischen den Elektroden des Lichtauskoppelsegmentes Z und des Koppelsegmentes 2 des Y-Lasers kann sich unmittelbar am Koppelsegment des herkömmlich geformten Y-Lasers befinden, sie kann jedoch auch von diesem entfernt angeordnet sein, so daß das Koppelsegment des Y-Lasers einen zusätzlichen Stumpf ST erhält, an den sich das Lichtauskoppelsegment anschließt.

Wie aus Fig. 1 a) und 1 b) ersichtlich, können die Lichtauskoppelsegmente in beliebige Richtungen weisen, beginnen jedoch immer am Koppelsegment 2, da nur dort eine hohe optische Leistung entnehmbar ist, ohne daß dadurch die Resonanzbedingungen der Laserkavitäten merklich gestört werden.

Fig. 2 zeigt eine optoelektronische Anordnung, in der ein interferometrischer Laser YL mit einem Wellenlängenkonverter WK optisch gekoppelt und monolithisch integriert ist. Die Kombination des interferometrischen Lasers mit einem Wellenlängenkonverter ist jedoch nicht die einzige in der optischen Nachrichtenübertragungstechnik nutzbare derartige Anordnung. Die Vorteile eines mit einem Lichtauskoppelsegment ausgestatteten interferometrischen Lasers als leistungsfähige, verlustarm ankoppelbare und problemlos monolithisch integrierbare Lichtquelle kommen auch in Kombinationen mit anderen optoelektronischen Bauelementen, insbesondere optischen Raumschaltern und optischen Halbleiter-Ringspeichern zur Geltung. Die Ankopplung des interferometrischen Lasers unterscheidet sich dort prinzipiell nicht von der im Zusammenhang mit Fig. 2 und Fig. 3 beschriebenen Ankopplung an einen Wellenlängenkonverter.

Der in Fig. 2 wiedergegebene interferometrische Y-Laser, der etwa dem in Fig. 1 a) dargestellten Y-Laser entspricht, speist Gleichlicht CW der Wellenlänge λ2 in einen dafür vorgesehenen Eingang E1 des Wellenlängenkonverters WK. In einen weiteren Eingang E2 des Wellenlängenkonverters wird moduliertes Licht der Wellenlänge λ1 eingestrahlt. Am Ausgang A des Wellenlängenkonverters kann moduliertes Licht der Wellenlänge λ2 entnommen werden. Als Wellenlängenkonverter ist hier eine Mach-Zehnder-Konfiguration zweier optischer Halbleiterverstärker OV1, OV2 gewählt, wie sie Fig. 10 des oben zuletzt zitierten Aufsatzes entspricht. Es ist jedoch auch jede andere Ausführungsform eines Wellenlängenkonverters einsetzbar.

Die Ankopplung des Y-Lasers an den Wellenlängenkonverter erfolgt hier nahezu verlustfrei, über einen durchgehenden ungestörten optischen Wellenleiter. Die Spiegelendflächen des Y-Lasers werden vorzugsweise durch die Spaltkanten SK des monolithisch integrierten Bauelementes gebildet. Wo dies nicht möglich ist, können Spiegelendflächen TS durch Trockenätzen erzeugt werden.

Wie beim Y-Laser werden auch beim nachgeschalteten Wellenlängenkonverter elektrisch getrennt steuerbare Segmente durch elektrische Unterbrechungen U in der den optischen Wellenleiterkavitäten aufliegenden Metallelektrode geschaffen. Wo die Unterbrechungen im einzelnen angeordnet sind, hängt von Anzahl und Ort der jeweils gewünschten, getrennten Steuerzugriffe ab.

Um zu verhindern, daß der interferometrische Laser durch Rückreflexionen gestört wird, sollten die Endflächen des mit dem Laser verbundenen Bauelementes entspiegelt sein. Ist eine Entspiegelung nicht möglich, so ist dafür zu sorgen, daß der Unterschied der optischen Weglängen der Laserarme viel kleiner als der zwischen der optischen Weglänge des Wurzelsegmentes des Lasers und der optischen Weglänge des nachfolgenden optoelektronischen Bauelementes ist. In der in Fig. 2 dargestellten Konfiguration eines Wellenlängenkonverters ist auch eine Beeinflussung des interferometrischen Lasers durch das in den zweiten Eingang des Wellenlängenkonverters eingestrahlte modulierte Licht der Wellenlänge λ1 nicht auszuschließen. Der Laser muß deshalb eine "harte" Filterwirkung auf der Wellenlänge λ2 zeigen.

Bei der in Fig. 3 wiedergegebenen Anordnung tritt das zuletzt erwähnte Problem nicht auf, da hier das modulierte Licht der Wellenlänge λ1 parallel zum Gleichlichtsignal des Lasers eingestrahlt wird. Hier treten jedoch am Ausgang A1 des Wellenlängenkonverters beide Signale mit Wellenlänge λ₁ und λ₂ moduliert aus. Um allein das modulierte Signal der Wellenlänge λ₂ zu erhalten, muß dem Ausgang A1 deshalb ein Wellenlängenfilter F nachgeschaltet werden.

## Patentansprüche

1. Interferometrischer Halbleiterlaser (YL) mit mehreren, unabhängig voneinander steuerbaren Segmenten (1 ... 4) und mit einem mit mehreren Segmenten verbundenen Koppelsegment (2), **gekennzeichnet durch** mindestens ein zusätzliches, mit dem Koppelsegment verbundenes Lichtauskoppelsegment (Z), das an seinem vom Koppelsegment abliegenden Ende zumindest weitgehend reflexionsfrei abgeschlossen ist.

2. Interferometrischer Halbleiterlaser nach Anspruch 1, dadurch gekennzeichnet, daß er die Form eines Y besitzt und neben dem Koppelsegment (2) mindestens zwei Armsegmente (3, 4), und ein Wurzelsegment (1) aufweist und daß das Koppelsegment die mindestens zwei Armsegmente und das Wurzelsegment miteinander verbindet.

3. Anordnung mit einem interferometrischen Laser nach Anspruch 1 oder 2, dadurch gekennzeichnet, daß das Lichtauskoppelsegment (Z) des interferometrischen Lasers an seinem vom Koppelsegment abliegenden Ende mit einem nachfolgenden optoelektronischen Bauelement (WK) optisch gekoppelt ist.

4. Anordnung nach Anspruch 3, dadurch gekennzeichnet, daß der interferometrische Laser und das nachfolgende optoelektronische Bauelement monolithisch integriert sind.

5. Anordnung nach Anspruch 4, dadurch gekennzeichnet, daß das Lichtauskoppelsegment und der Teil des nachfolgenden optoelektronischen Bauelementes, in den eine Einkopplung optischer Leistung aus dem Lichtauskoppelsegment heraus erfolgt, im Koppelbereich einen durchgehenden, ungestörten optischen Wellenleiter bilden.

6. Anordnung nach Anspruch 3, dadurch gekennzeichnet, daß das Lichtauskoppelsegment und der Teil des nachfolgenden optoelektronischen Bauelementes, in den eine Einkopplung optischer Leistung aus dem Lichtauskoppelsegment heraus erfolgt, über eine Stoßkopplung oder eine Hybridkopplung miteinander optisch gekoppelt sind.

7. Anordnung nach einem der Ansprüche 3 bis 6, dadurch gekennzeichnet, daß als nachfolgendes Bauelement ein optischer Raumschalter vorgesehen ist.

8. Anordnung nach einem der Ansprüche 3 bis 6, dadurch gekennzeichnet, daß als nachfolgendes Bauelement ein optischer Speicher vorgesehen ist.

9. Anordnung nach einem der Ansprüche 3 bis 6, dadurch gekennzeichnet, daß als nachfolgendes optoelektronisches Bauelement ein Wellenlängenkonverter vorgesehen ist.

10. Anordnung nach Anspruch 9, dadurch gekennzeichnet, daß der Wellenlängenkonverter ein interferometrischer Wellenlängenkonverter ist.

## Claims

1. An interferometric semiconductor laser (YL) having several independently controllable segments (1 ... 4) and a coupling segment (2) connected to several segments, **characterized by** at least one additional light output segment (Z) which is connected to the coupling segment and is terminated at its end remote from the coupling segment by an at least substantially reflectionless termination.

2. An interferometric semiconductor laser as claimed in claim 1, characterized in that it is shaped like a Y and has, besides the coupling segment (2), at least two arm segments (3, 4) and a root segment (1), and that the coupling segment interconnects the at least two arm segments and the root segment.

3. An arrangement comprising an interferometric laser as claimed in claim 1 or 2, characterized in that at its end remote from the coupling segment, the light output segment (Z) of the interferometric laser is optically coupled to a subsequent optoelectronic component (WK).

4. An arrangement as claimed in claim 3, characterized in that the interferometric laser and the subsequent optoelectronic component are monolithically integrated.

5. An arrangement as claimed in claim 4, characterized in that the light output segment and that portion of the subsequent optoelectronic component into which optical power is coupled from the light output segment form a continuous, unperturbed optical waveguide in the coupling region.

6. An arrangement as claimed in claim 3, characterized in that the light output segment and that portion of the subsequent optoelectronic component into which optical power is coupled from the light output segment are optically coupled by butt coupling or hybrid coupling.

7. An arrangement as claimed in any one of claims 3 to 6, characterized in that the subsequent component is an optical space switch.

8. An arrangement as claimed in any one of claims 3 to 6, characterized in that the subsequent component is an optical storage device.

9. An arrangement as claimed in any one of claims 3 to 6, characterized in that the subsequent optoelectronic component is a wavelength converter.

10. An arrangement as claimed in claim 9, characterized in that the wavelength converter is an interferometric wavelength converter.

## Revendications

1. Laser interférométrique à semi-conducteurs (YL) composé de plusieurs segments (1...4) commandables individuellement et d'un segment de couplage (2) lui-même relié à plusieurs segments **caractérisé par** au moins un segment d'extraction de lumière (Z) supplémentaire, relié au segment de couplage et ne présentant pratiquement pas de réflexion sur son extrémité opposée au segment de couplage.

2. Laser interférométrique à semi-conducteurs suivant la revendication 1 **caractérisé par** sa forme en Y et par la présence d'au moins deux branches (3,4) et d'une racine (1) en plus du segment de couplage (2), et par le fait que le segment de couplage réalise au moins la liaison entre les deux branches et la racine.

3. Disposition comportant un laser interférométrique selon la revendication 1 ou 2 **caractérisée par** le fait que l'extrémité du segment d'extraction de lumière (Z) du laser interférométrique opposé au segment de couplage est couplée à un composant optique (WK) lui succédant.

4. Disposition selon la revendication 3, **caractérisée par** le fait que le laser interférométrique et les composants optoélectroniques lui succédant sont obtenus par intégration monolithique.

5. Disposition selon la revendication 4 **caractérisée par** le fait que le segment d'extraction de lumière et la partie du composant optoélectronique lui succédant et par lequel s'effectue le couplage de la puissance optique provenant du segment d'extraction de lumière, forment dans la zone de couplage, un guide d'ondes optique continu et sans perturbations.

6. Disposition selon la revendication 3 **caractérisée par** le fait que le segment d'extraction de lumière et la partie du composant optoélectronique lui succédant et par lequel s'effectue le couplage de la puissance optique provenant du segment d'extraction de lumière, sont reliés entre eux par une jonction par juxtaposition ou hybridé.

7. Disposition selon les revendications 3 à 6, **caractérisée par** le fait que le composant succédant est constitué par un contact volumique optique.

8. Disposition selon les revendications 3 à 6, **caractérisée par** le fait que le composant succédant est constitué par une mémoire optique.

9. Disposition selon les revendications 3 à 6, **caractérisée par** le fait que le composant optoélectronique lui succédant est constitué par un convertisseur de longueur d'onde.

10. Disposition selon la revendication 9, **caractérisée par** le fait que le convertisseur de longueur d'onde est constitué d'un convertisseur de longueur d'onde interférométrique.
